# EUROPEAN PATENT SPECIFICATION

(11) **EP 1 702 906 B1**
(45) Date of publication and mention of the grant of the patent: **29.08.2012**
(21) Application number: 04807448.8
(22) Date of filing: 21.12.2004
(51) Int. Cl.: C04B 35/495, H01L 41/187, H01L 41/24

(54) **PIEZOELECTRIC PORCELAIN AND METHOD FOR PRODUCTION THEREOF**
PIEZOELEKTRISCHES PORZELLAN UND HERSTELLUNGSVERFAHREN DAFÜR
PORCELAINE PIEZO-ELECTRIQUE ET SON PROCEDE DE PRODUCTION

(30) Priority: 22.12.2003 JP 2003424866
(43) Date of publication of application: 20.09.2006
(73) Proprietor: TDK Corporation, Chuo-ku, Tokyo 103-8272 (JP)
(72) Inventor: FURUKAWA, Masahito, Chuo-ku, Tokyo 103-8272 (JP); NANAO, Masaru, Chuo-ku, Tokyo 103-8272 (JP); MUROSAWA, Shougo, Chuo-ku, Tokyo 103-8272 (JP); SATOU, Naoyoshi, Chuo-ku, Tokyo 103-8272 (JP); KURODA, Tomofumi, Chuo-ku, Tokyo 103-8272 (JP)
(74) Representative: Müller - Hoffmann & Partner
(86) International application number: PCT/JP2004/019091
(87) International publication number: WO 2005/061413

(56) References cited:
- WO-A1-02/102738
- JP-A- 2002 160 967

## Description

### TECHNICAL FIELD

The present invention relates to a piezoelectric ceramic including a composition including a perovskite-type oxide and a tungsten bronze-type oxide, and being suitable for vibration devices such as actuators, sound components, sensors and so on, and a method of manufacturing the same.

### BACKGROUND ART

An actuator using a piezoelectric ceramic uses a piezoelectric effect in which the application of an electric field generates mechanical strain and stress. The actuator has characteristics such as the capability of obtaining a very small displacement with high accuracy, and large strain, and, for example, the actuator is used to position a precision tool or an optical device. As a conventional piezoelectric ceramic used for actuators, lead zirconate titanate (PZT) having excellent piezoelectric properties is most commonly used. However, lead zirconate titanate includes a large amount of lead, so adverse effects on global environment such as leaching of lead caused by acid rain have become issues recently. Therefore, the development of piezoelectric ceramics not including lead instead of lead zirconate titanate is desired.

As the piezoelectric ceramic not including lead, for example, a piezoelectric ceramic including barium titanate (BaTiO₃) as a main component is known (refer to Japanese Unexamined Patent Application Publication No. H2-159079). The piezoelectric ceramic is superior in a relative dielectric constant ε r and a electromechanical coupling factor kr, so the piezoelectric ceramic holds promise as a piezoelectric material for actuators. Moreover, as another piezoelectric ceramic not including lead, for example, a piezoelectric ceramic including sodium lithium potassium niobate as a main component is known (refer to Japanese Unexamined Patent Application Publication No. S49-125900 or Japanese Examined Patent Publication No. S57-6713). The piezoelectric ceramic has a high Curie temperature of 350°C or over, and an excellent electromechanical coupling factor kr, so the piezoelectric ceramic holds promise as a piezoelectric material. Further, a compound including potassium sodium niobate and a tungsten bronze-type oxide has been recently reported (Japanese Unexamined Patent Application Publication No. H9-165262).

EP-A1-1405836 discloses a piezoelectric ceramic including sodium potassium niobate, barium titanate and a tungsten bronze-type oxide.

However, the piezoelectric ceramics not including lead have such an issue that they have lower piezoelectric properties, compared to lead-based piezoelectric ceramics, thereby a sufficiently large amount of displacement cannot be obtained. Moreover, in the piezoelectric ceramic including sodium lithium potassium niobate as a main component, sodium, potassium and lithium are easily volatilized during sintering, so there is such an issue that sintering is difficult.

### DISCLOSURE OF THE INVENTION

In view of the foregoing, it is an object of the invention to provide a piezoelectric ceramic being capable of obtaining a large amount of displacement, and being easily sintered, and being superior in the point of low emission, environment and ecology, and a method of manufacturing the same.

A piezoelectric ceramic according to the invention includes: a composition including a first perovskite-type oxide, a second perovskite-type oxide and a tungsten bronze-type oxide, wherein the first perovskite-type oxide includes a first element including sodium (Na) and potassium (K), a second element including at least niobium (Nb) selected from the group consisting of niobium and tantalum (Ta), and oxygen (O), the second perovskite-type oxide includes at least strontium (Sr) selected from an alkaline-earth metal element, a fourth element including zirconium (Zr), and oxygen, and the content of the second perovskite-type oxide in the composition is less than 10 mol%.

The content of potassium in the first element is preferably within a range from 10 mol% to 90 mol% inclusive. The first element preferably further includes lithium, and the content of lithium in the first element is preferably 10 mol% or less.

Moreover, the content of the tungsten bronze-type oxide in the composition is preferably 1 mol% or less. The tungsten bronze-type oxide preferably includes a fifth element including an alkaline-earth metal element, a sixth element including at least niobium selected from the group consisting of niobium and tantalum, and oxygen.

Further, the total content of tantalum in the second element and the sixth element is preferably within a range from 0 mol% to 10 mol% inclusive.

In addition, the composition is considered as a main component, and as a sub-component, at least one kind selected from the group consisting of elements of Groups 3 through 14 in the long form of the periodic table of the elements, more specifically manganese (Mn) is preferably included, and in addition to manganese, at least one kind selected from the group consisting of cobalt (Co), iron (Fe), nickel (Ni), zinc (Zn), scandium (Sc), titanium (Ti), zirconium (Zr), hafnium (Hf), aluminum (Al), gallium (Ga), indium (In), silicon (Si), germanium (Ge) and tin (Sn) is more preferably included.

A method of manufacturing a piezoelectric ceramic according to the invention, the piezoelectric ceramic including a first perovskite-type oxide, a second perovskite-type oxide and a tungsten bronze-type oxide, the first perovskite-type oxide including a first element including sodium (Na) and potassium (K), a second element including at least niobium (Nb) selected from the group consisting of niobium and tantalum (Ta) and oxygen (O), the second perovskite-type oxide including at least strontium (Sr) selected from at least one kind selected from alkaline-earth metal elements, a fourth element including zirconium (Zr) and oxygen, the method includes the step of: calcining a mixture including elements of the first perovskite-type oxide, the second perovskite-type oxide, and elements of the tungsten bronze-type oxide.

In the piezoelectric ceramic according to the invention, the first perovskite-type oxide including sodium, potassium and niobium, the second perovskite-type oxide including an alkaline-earth metal element and zirconium, and the tungsten bronze-type oxide are included, and the content of the second perovskite-type oxide in the main component is less than 10 mol%, so the amount of displacement can be increased. Moreover, sintering can be easily performed. Therefore, availability of the piezoelectric ceramic and the piezoelectric device including no lead or a smaller content of lead can be increased. In other words, the volatilization of lead during sintering is reduced, and the risk of emitting lead into environment is lower even after the piezoelectric ceramic and the piezoelectric device are distributed in a market and then disposed, so the piezoelectric ceramic and the piezoelectric device being superior in the point of low emission, environment and ecology can be utilized.

In particular, when the content of potassium in the first element is within a range from 10 mol% to 90 mol% inclusive, superior piezoelectric properties can be obtained, and sintering can be more easily performed.

Moreover, when the first element includes 10 mol% or less of lithium, the amount of displacement can be further increased.

Further, when the content of the tungsten bronze-type oxide in the composition is 1 mol% or less, the amount of displacement can be further increased.

In addition, when the tungsten bronze-type oxide includes the third element including an alkaline-earth metal element, the fourth element including at least niobium selected from the group consisting of niobium and tantalum, and oxygen, superior piezoelectric properties can be obtained.

Furthermore, when the total content of tantalum in the second element and the sixth element is 10 mol% or less, the amount of displacement can be further increased.

In addition, when at least one kind selected from selected from the group consisting of elements of Groups 3 through 14 in the long form of the periodic table of the elements is included as the sub-component, the piezoelectric properties can be further improved. In particular, when manganese as an oxide is included as the first sub-component within a range of 0.1 wt% to 1 wt% inclusive relative to the main component, the sinterability can be improved, thereby the piezoelectric properties can be improved. Further, when, in addition to manganese, at least one kind selected from the group consisting of cobalt, iron, nickel, zinc, scandium, titanium, zirconium, hafnium, aluminum, gallium, indium, silicon, germanium and tin as an oxide is included as a second sub-component within a range from 0.01 wt% to 1 wt% relative to the main component in total, the piezoelectric properties can be further improved.

Moreover, in the method of manufacturing a piezoelectric ceramic according to the invention, a mixture including elements of the first perovskite-type oxide, the second perovskite-type oxide, and elements of the tungsten bronze-type oxide is calcined, so the piezoelectric ceramic according to the invention can be easily obtained, and the piezoelectric ceramic according to the invention can be achieved.

### BRIEF DESCRIPTION OF THE DRAWINGS

FIG. 1 is an illustration of a piezoelectric device using a piezoelectric ceramic according to an embodiment of the invention;
FIG. 2 is a flowchart showing a method of manufacturing the piezoelectric ceramic according to the embodiment of the invention and a piezoelectric device; and
FIG. 3 is an illustration of a displacement measuring device used for measuring the amount of displacement in examples of the invention.

### BEST MODE FOR CARRYING OUT THE INVENTION

A preferred embodiment of the present invention will be described in more detail below.

A piezoelectric ceramic according to an embodiment of the invention includes a composition including a first perovskite-type oxide, a second perovskite-type oxide and a tungsten bronze-type oxide as a main component. In the composition, the first perovskite-type oxide, the second perovskite-type oxide and the tungsten bronze-type oxide may form a solid solution, or may not perfectly form a solid solution.

The first perovskite-type oxide includes a first element, a second element and oxygen. The first element includes at least sodium and potassium, and preferably further includes lithium. The second element includes at least niobium, and preferably further includes tantalum. It is because in this case, superior piezoelectric properties can be obtained by including no lead or reducing the content of lead. Further, it is because the Curie temperature can be increased, thereby an operating temperature range can be extended. The chemical formula of the first perovskite-type oxide is represented by, for example, Chemical Formula 1.

[Chemical Formula 1] (Na_{1-x-y}KₓLi_{y})ₚ(Nb_{1-z}Ta_{z})O₃

In the formula, the values of x, y and z are within a range of 0<x<1, 0≦<1 and 0≦z<1, respectively. When the first perovskite-type oxide has a stoichiometric composition, p is 1, but the perovskite-type oxide may deviate from the stoichiometric composition. The composition of oxygen is stoichiometrically determined, and it may deviate from the stoichiometric composition.

The content of potassium in the first element is preferably within a range of 10 mol% to 90 mol% inclusive. In other words, for example, the value of x in Chemical Formula 1 is preferably within a range of 0.1 ≦x≦ 0.9 at molar ratio. It is because when the content of potassium is too small, a relative dielectric constant εr, an electromechanical coupling factor kr, and the amount of displacement cannot be sufficiently increased, and when the content of potassium is too large, vigorous volatilization of potassium occurs during sintering, so it is difficult to perform sintering.

The content of lithium in the first element is preferably within a range from 0 mol% to 10 mol% inclusive. In other words, for example, the value of y in Chemical Formula 1 is preferably within a range of 0≦y≦0.1 at molar ratio. It is because when the content of lithium is too large, the relative dielectric constant εr, the electromechanical coupling factor kr and the amount of displacement cannot be sufficiently increased.

A composition ratio of the first element to the second element (the first element/the second element), that is, for example, the value of p in Chemical Formula 1 is preferably within a range of 0.95 to 1.05 inclusive at molar ratio. It is because when it is less than 0.95, the relative dielectric constant ε r, the electromechanical coupling factor kr and the amount of displacement become smaller, and when it is larger than 1.05, polarization is difficult due to a decline in sintering density.

The second perovskite-type oxide includes a third element including at least an alkaline-earth metal element and a fourth element including at least zirconium, and oxygen. As the alkaline-earth metal element, at least one kind selected from the group consisting of magnesium, calcium, strontium and barium is preferable. It is because in such a case, superior piezoelectric properties can be obtained. The chemical formula of the second perovskite-type oxide is represented by, for example, Chemical Formula 2.

[Chemical Formula 2] (M1)ZrO₃

In the formula, M1 represents the third element. The composition ratio of the third element, the fourth element (Zr) and oxygen is stoichiometrically determined, and may deviate from the stoichiometric composition.

The tungsten bronze-type oxide includes a fifth element, a sixth element and oxygen. The fifth element preferably includes, for example, at least an alkaline-earth metal element, and more preferably includes at least one kind selected from the group consisting of magnesium, calcium, strontium and barium. The sixth element includes, for example, at least niobium, and preferably further includes tantalum. It is because in such a case, superior piezoelectric properties can be obtained by including no lead or reducing the content of lead. The chemical formula of the tungsten bronze-type oxide is represented by, for example, Chemical Formula 3.

[Chemical Formula 3] M2(Nb_{1-w}T_{aw})₂O₆

In the formula, M2 represents the fifth element, and the value of w is within a range of 0≦w<1. The composition ratio of the fifth element, the sixth element (Nb_{1-w}Ta_{w}) and oxygen is stoichiometrically determined, and may deviate from the stoichiometric composition.

The sixth element may be the same as or different from the second element. The total content of tantalum in the second element and the sixth element is preferably 10 mol% or less. It is because when the content of tantalum is too large, the Curie temperature is decreased, and the electromechanical coupling factor kr and the amount of displacement become smaller.

A composition ratio of the first perovskite-type oxide, the second perovskite-type oxide and the tungsten bronze-type oxide is preferably within a range shown in Chemical Formula 4 at molar ratio. More specifically, the content of the second perovskite-type oxide in the composition is preferably larger than 0 mol% and less than 10 mol%. It is because when the second perovskite-type oxide is included, the relative dielectric constant ε r and the amount of displacement can be increased; however, when the content of the second perovskite-type oxide is too large, it is difficult to perform sintering. The content of the tungsten bronze-type oxide is preferably larger than 0 mol% and equal to or less than 1 mol%. It is because when the tungsten bronze-type oxide is included, sintering can be performed more easily, and the relative dielectric constant ε r, the electromechanical coupling factor kr and the amount of displacement can be increased; however, when the content of the tungsten bronze-type oxide is too large, the electromechanical coupling factor kr and the amount of displacement become smaller.

[Chemical Formula 4] (1-m-n)A+mB+nC

In the formula, A represents the first perovskite-type oxide, B represents the second perovskite-type oxide, and C represents the tungsten bronze-type oxide, and the values of m and n are within a range of 0<m< 0.1 and 0<n≦0.01, respectively.

The piezoelectric ceramic preferably includes at least one kind selected from elements of Groups 3 through 14 in the long form of the periodic table of the elements as a sub-component in addition to the above composition as the main component. It is because the piezoelectric properties can be further improved. The sub-component may exist as an oxide in a grain boundary of the composition as the main component, or may exist by being dispersed in a part of the composition as the main component.

As the sub-component, manganese is preferably included as a first sub-component. It is because sinterability is improved, thereby the piezoelectric properties can be improved. The content of manganese as an oxide (MnO) is preferably within a range from 0.1 wt% to 1 wt% inclusive relative to the main component. It is because the sinterability can be improved within the range.

As the sub-component, in addition to manganese, at least one kind selected from the group consisting of cobalt, iron, nickel, zinc, scandium, titanium, zirconium, hafnium, aluminum, gallium, indium, silicon, germanium and tin is preferably included as a second sub-component. It is because in addition to an improvement in sinterability, the second sub-component has a function of improving the piezoelectric properties. The total content of the second sub-component as an oxide (Co₃O₄, Fe₂O₃, NiO, ZnO, Sc₂O₃, TiO₂, ZrO₂, HfO₂ Al₂O₃, Ga₂O₃, In₂O₃, SiO₂, GeO₂, SnO₂) is preferably within a range of 0.01 wt% to 1 wt% inclusive relative to the main component. It is because properties can be improved within the range.

In addition, the piezoelectric ceramic may include lead (Pb), but the content of lead is preferably within a range of 1 wt% or less, and more preferably, no lead is included. It is because the volatilization of lead during sintering, and the emission of lead into environment after the piezoelectric ceramic is distributed in a market as a piezoelectric part, and then disposed can be minimized, and it is preferable in the point of low emission, environment and ecology.

The piezoelectric ceramic is preferably used as, for example, a material of a vibration device such as an actuator, a sound component, a sensor or the like which is a piezoelectric device.

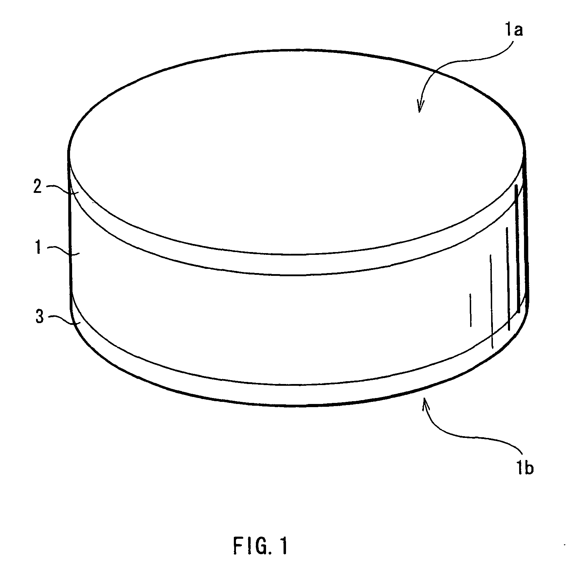

FIG. 1 shows an example of a piezoelectric device using the piezoelectric ceramic according to the embodiment. The piezoelectric device includes a piezoelectric substrate 1 made of the piezoelectric ceramic according to the embodiment, and a pair of electrodes 2 and 3 disposed on a pair of facing surfaces 1a and 1b of the piezoelectric substrate 1, respectively. The piezoelectric substrate 1 is polarized, for example, in a thickness direction, that is, a direction where the electrodes 2 and 3 face each other, and the application of a voltage through the electrodes 2 and 3 causes longitudinal vibration in a thickness direction and extensional vibration in a diameter direction.

The electrodes 2 and 3 are made of, for example, metal such as gold (Au), and are disposed on the whole facing surfaces 1a and 1b of the piezoelectric substrate 1, respectively. The electrodes 2 and 3 are electrically connected to an external power source (not shown) through a wire (not shown).

For example, the piezoelectric ceramic and the piezoelectric device having such a structure can be manufactured as follows.

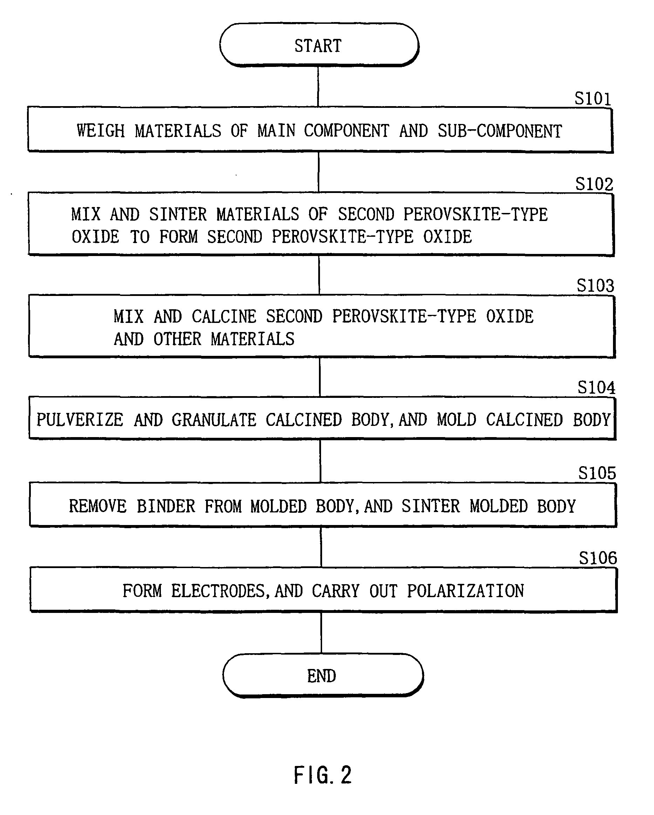

FIG. 2 shows a flowchart showing a method of manufacturing the piezoelectric ceramic. At first, as materials of the elements of the main component, for example, oxide powders including sodium, potassium, lithium, niobium, tantalum, an alkaline-earth metal element and zirconium are prepared as required. Further, as a material of the sub-component, for example, an oxide powder including at least one kind selected from elements of Groups 3 through 14 in the long form of the periodic table of the elements, for example, manganese, cobalt, iron, nickel, zinc, scandium, titanium, zirconium, hafnium, aluminum, gallium, indium, silicon, germanium and tin is prepared as required. As the materials of the main component and the sub-component, materials such as carbonates or oxalates which become oxides by sintering may be used instead of the oxides. Next, after these materials are sufficiently dried, the materials are weighed so that the final composition is within the above-described range (step S101).

Next, for example, after the materials of the second perovskite-type oxide are sufficiently mixed in an organic solvent or water by a ball mill or the like, the materials are dried, and sintered at 1000°C to 1200°C for 2 hours to 4 hours so as to form the second perovskite-type oxide (step S102).

After the second perovskite-type oxide is formed, the second perovskite-type oxide, the materials of the first perovskite-type oxide and the materials of the tungsten bronze-type oxide are sufficiently mixed in an organic solvent or water by a ball mill or the like to form a mixture. After that, the mixture is dried and press-molded, and then calcined at 750°C to 1100°C for 1 to 4 hours (step S103). As described above, the second perovskite-type oxide is formed, and then other materials of the main component are mixed with the second perovskite-type oxide, because if the materials of the second perovskite-type oxide and the materials of the first perovskite-type oxide are mixed and sintered, the materials of the second perovskite-type oxide react with the first perovskite-type oxide, thereby the second perovskite-type oxide is not formed.

After calcining, for example, the calcined material is sufficiently pulverized by a ball mill or the like in an organic solvent or water, and is dried again, then a binder is added to the material to granulate the material. After granulating, the granulated powder is press-molded by the use of a uniaxial press, a cold isostatic press (CIP) or the like (step S104).

After molding, for example, the molded body is heated to remove the binder, and then is further sintered at 950°C to 1350°C for 2 to 4 hours (step S105). After sintering, the obtained sintered body is processed as required to form the piezoelectric substrate 1, and the electrodes 2 and 3 are disposed on the piezoelectric substrate 1, and then an electric field is applied to the piezoelectric substrate 1 in heated silicon oil to carry out polarization (step S106). Thereby, the above-described piezoelectric ceramic and the piezoelectric device shown in FIG. 1 can be obtained.

Thus, in the embodiment, the first perovskite-type oxide including sodium, potassium and niobium, the second perovskite-type oxide including an alkaline-earth metal element and zirconium and the tungsten bronze-type oxide are included, and the content of the second perovskite-type oxide in the main component is less than 10 mol%, so the relative dielectric constant ε r, the electromechanical coupling factor kr and the amount of displacement can be increased. Further, sintering can be easily performed.

Therefore, availability of the piezoelectric ceramic and the piezoelectric device including no lead or a smaller content of lead can be increased. In other words, the volatilization of lead during sintering is reduced, and the risk of emitting lead into environment is lower even after the piezoelectric ceramic and the piezoelectric device are distributed in a market and then disposed, so the piezoelectric ceramic and the piezoelectric device being superior in the point of low emission, environment and ecology can be utilized.

More specifically, when the content of potassium in the first element is within a range of 10 mol% to 90 mol% inclusive, superior piezoelectric properties can be obtained, and sintering can be more easily performed.

Moreover, when 10 mol% or less of lithium is included as the first element, or when the composition ratio of the first element to the second element (the first element/the second element) is within a range from 0.95 to 1.05 inclusive at molar ratio, the relative dielectric constant ε r, the electromechanical coupling factor kr and the amount of displacement can be further increased.

Further, when the content of the tungsten bronze-type oxide in the composition is within a range of 1 mol% or less, the electromechanical coupling factor kr and the amount of displacement can be further increased.

In addition, when the tungsten bronze-type oxide includes the fifth element including an alkaline-earth metal element, the sixth element including at least niobium selected from the group consisting of niobium and tantalum, and oxygen, and specifically when the fifth element includes at least one kind selected from the group consisting of magnesium, calcium, strontium and barium, superior piezoelectric properties can be obtained.

Moreover, when the total content of tantalum in the second element and the sixth element is within a range of 10 mol% or less, the electromechanical coupling factor kr and the amount of displacement can be further increased.

Further, when at least one kind selected from elements of Groups 3 through 14 in the long form of the periodic table of the elements is included as the sub-component, the piezoelectric properties can be further improved. In particular, when manganese as an oxide is included within a range from 0.1 wt% to 1 wt% inclusive relative to the main component as the first sub-component, sinterability is improved, thereby the piezoelectric properties can be improved. Further, when, in addition to manganese, at least one kind selected from the group consisting of cobalt, iron, nickel, zinc, scandium, titanium, zirconium, hafnium, aluminum, gallium, indium, silicon, germanium and tin as an oxide is included as the second sub-component within a range from 0.01 wt% to 1 wt% inclusive relative to the main component in total, the piezoelectric properties can be further improved.

In addition, when the second perovskite-type oxide, the materials of the elements of the first perovskite-type oxide and the materials of the elements of the tungsten bronze-type oxide are mixed, calcined and sintered, the piezoelectric ceramic according to the embodiment can be easily obtained, and the piezoelectric ceramic according to the embodiment can be achieved.

### Examples]

Next, specific examples of the invention will be described below.

### (Examples 1-1, 1-2)

A piezoelectric ceramic including, as a main component, a composition represented by Chemical Formula 5 which included the first perovskite-type oxide, the second perovskite-type oxide and the tungsten bronze-type oxide was used to form a piezoelectric device shown in FIG. 1 through the steps shown in FIG. 2. Examples 1-1 and 1-2 will be described referring to FIGs. 1 and 2 using numerals shown in FIG. 1.

[Chemical Formula 5] (0.995-ₘ)(Na_{0.57}K_{0.38}Li_{0.05})NbO₃+ₘSrZrO₃+0.005BaNb₂O₆

At first, as materials of the main component, a sodium carbonate (Na₂CO₃) powder, a potassium carbonate (K₂CO₃) powder, a lithium carbonate (Li₂CO₃) powder, a niobium oxide (Nb₂O₅) powder, a strontium carbonate (SrCO₃) powder, a zirconium oxide (ZrO₂) powder and a barium carbonate (BaCO₃) powder were prepared. Moreover, as a material of the sub-component, a manganese carbonate (MnCO₃) powder was prepared. Next, after the materials of the main component and the sub-component were sufficiently dried, they were weighed so that the main component became the composition shown in Chemical Formula 5 and Table 1, and the content of manganese which was the sub-component as an oxide was 0.31 wt% relative to the main component (refer to step S101 in FIG. 2). The weights of the carbonates among the materials of the main component were calculated as oxides formed through dissociating CO₂ from the carbonates, and as the content of the sub-component, the amount of the mixed manganese carbonate powder which was the material of the sub-component was 0.5 wt% relative to the total weight of the materials of the main component.

**[Table 1]**

| | COMPOSITION OF MAIN COMPONENT m(mol) | CONTENT OF SUB-COMPONENT Mn* (WT%) | RELATIVE DIELECTRIC CONSTANT *ε* r | ELECTROMECHANICAL COUPLING FACTOR Kr (%) | AMOUNT OF DISPLACEMENT (%) |
|---|---|---|---|---|---|
| EXAMPLE 1-1 | 0.005 | 0.31 | 737 | 38.2 | 0.086 |
| EXAMPLE 1-2 | 0.01 | 0.31 | 889 | 40.4 | 0.100 |
| COMPARATIVE EXAMPLE 1-1 | 0 | 0.31 | 535 | 43.1 | 0.083 |
| COMPARATIVE EXAMPLE 1-2 | 0.1 | 0.31 | — | — | — |

| | | | | | |
|---|---|---|---|---|---|
| * The content of the sub-component is a value as an oxide (MnO) relative to the main component. | | | | | |

Next, after the strontium carbonate powder and the zirconium powder were mixed in water by a ball mill, and dried, the mixture was sintered at 1100°C for 2 hours so as to form strontium zirconate as the second perovskite-type oxide (refer to step S102 in FIG. 2).

After strontium zirconate was formed, strontium zirconate, other materials of the main component and the materials of the sub-component were mixed in water by a ball mill, dried, press-molded and calcined for 2 hours at 850°C to 1000°C (refer to step S103 in FIG. 2). After calcining, the calcined body was pulverized by a ball mill in water, and was dried again, and then polyvinyl alcohol was added to the body to granulate the body. After granulating, the granulated powder was molded by the use of a uniaxial press at a pressure of approximately 40 MPa so as to form a disk shaped pellet with a diameter of 17 mm (refer to step S104 in FIG. 2).

After molding, the molded body was heated for 4 hours at 650°C to remove the binder, and then the molded body was further sintered at 950°C to 1350°C for 4 hours (refer to step S105 in FIG. 2). After that, the sintered body was processed into a disk shape with a thickness of 0.6 mm so as to form the piezoelectric substrate 1, and a silver paste was printed on both sides of the piezoelectric substrate 1, and baked at 650°C so as to form the electrodes 2 and 3. After forming the electrodes 2 and 3, an electric field of 3 kV/mm to 10 kV/mm was applied to the piezoelectric substrate 1 in silicon oil of 30°C to 250°C for 1 to 30 minutes to carry out polarization (refer to step S106 in FIG. 2). Thereby, the piezoelectric devices of Examples 1-1 and 1-2 were obtained.

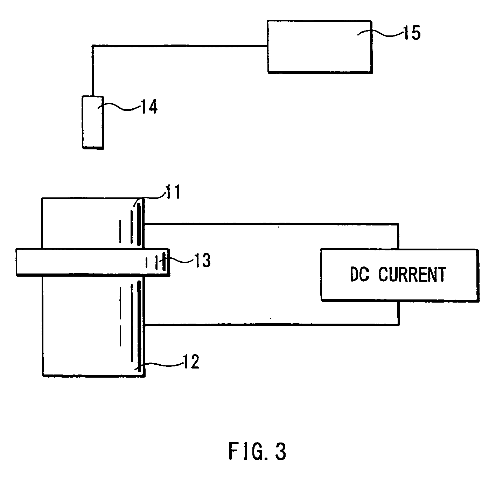

After the obtained piezoelectric devices of Examples 1-1 and 1-2 were left alone for 24 hours, as the piezoelectric properties, the relative dielectric constant εr, the electromechanical coupling factor kr, and the amount of displacement in the case where an electric field of 3 kV/mm was applied were measured. The relative dielectric constant ε r and the electromechanical coupling factor kr were measured by an impedance analyzer (Hewlett-Packard's HP4194A), and a frequency when measuring the relative dielectric constant ε r was 1 kHz. The amount of displacement was measured by a displacement measuring device using eddy currents as shown in FIG. 3. In the displacement measuring device, a test sample 13 was sandwiched between a pair of electrodes 11 and 12, and the displacement of the test sample 13 when a direct current was applied was detected by a displacement sensor 14, and then the amount of displacement was determined by a displacement detector 15. These results are shown in Table 1. The amount of displacement shown in Table 1 was determined by dividing the measured value by the thickness of the test sample and then multiplying by 100 (the measured value/the thickness of the test sample X 100).

As Comparative Example 1-1 relative to the examples, a piezoelectric device was formed as in the case of Examples 1-1 and 1-2, except that strontium zirconate as the second perovskite-type oxide was not included, that is, the value of m in Chemical Formula 5 was 0. Moreover, as Comparative Example 1-2 relative to the examples, a piezoelectric device was formed as in the case of Examples 1-1 and 1-2, except that the content of strontium zirconate in the main component was 10 mol%, that is, the value of m in Chemical Formula 5 was 0.1. The content of the sub-component was the same as that in Examples 1-1 and 1-2.

The relative dielectric constant ε r, the electromechanical coupling factor kr and the amount of displacement in the case where an electric field of 3 kV/mm was applied in the piezoelectric devices of Comparative Examples 1-1 and 1-2 were measured as in the case of Examples 1-1 and 1-2. These results are also shown in Table 1.

As shown in Table 1, Examples 1-1 and 1-2 could obtain higher values of the relative dielectric constant εr and the amount of displacement than those in Comparative Example 1-1 in which no strontium zirconate was included. Moreover, there was a tendency that as the value of m in Chemical Formula 5 increased, that is, as the content of strontium zirconate increased, the relative dielectric constant ε r and the amount of displacement increased. Further, in Comparative Example 1-2 in which the content of strontium zirconate was 10 mol%, sintering could not be performed, thereby the properties could not be measured.

In other words, it was clear that when the second perovskite-type oxide was included within a range of less than 10 mol% in the main component in addition to the first perovskite-type oxide and the tungsten bronze-type oxide, the amount of displacement could be increased.

### (Examples 1-3 to 1-5)

Piezoelectric devices of Examples 1-3 through 1-5 were formed as in the case of Example 1-2, except that a composition shown in Chemical Formula 6 was included as the main component. At that time, in Examples 1-3 through 1-5, the third element (M1 in Chemical Formula 6) was changed as shown in Table 2. As the materials of magnesium, calcium and barium, a basic manganese carbonate (4MgCO₃ · Mg(OH)₂ · 4H₂O) powder, a calcium carbonate (CaCO₃) powder and a barium carbonate powder were used. The content of the sub-component was the same as that in Example 1-2.

[Chemical Formula 6] 0.985(Na_{0.57}K_{0.38}Li_{0.05})NbO₃+0.01M1ZrO₃+0.005BaNb₂O₆

**[Table 2]**

| | COMPOSITION OF MAIN COMPONENT M1 | CONTENT OF SUB-COMPONENT Mn* (WT%) | RELATIVE DIELECTRIC CONSTANT *ε* r | ELECTROMECHANICAL COUPLING FACTOR Kr (%) | AMOUNT OF DISPLACEMENT (%) |
|---|---|---|---|---|---|
| EXAMPLE 1-2 | Sr | 0.31 | 889 | 40.4 | 0.100 |
| EXAMPLE 1-3 | Mg | 0.31 | 791 | 37.2 | 0.087 |
| EXAMPLE 1-4 | Ca | 0.31 | 852 | 38.0 | 0.092 |
| EXAMPLE 1-5 | Ba | 0.31 | 820 | 37.9 | 0.090 |
| COMPARATIVE EXAMPLE 1-1 | — | 0.31 | 535 | 43.1 | 0.083 |

| | | | | | |
|---|---|---|---|---|---|
| * The content of the sub-component is a value as an oxide (MnO) relative to the main component. | | | | | |

The relative dielectric constant ε r, the electromechanical coupling factor kr and the amount of displacement in the case where an electric field of 3 kV/mm was applied in the piezoelectric devices of Examples 1-3 through 1-5 were measured as in the case of Example 1-2. The results are shown in Table 2 together with the results of Example 1-2 and Comparative Example 1-1.

As shown in Table 2, as in the case of Example 1-2, Examples 1-3 through 1-5 could obtain higher values of relative dielectric constant ε r and the amount of displacement. In other words, it was clear that even if the third element was changed, the piezoelectric properties could be improved, and the amount of displacement could be increased.

### (Examples 2-1 to 2-7)

Piezoelectric devices were formed as in the case of Examples 1-1 and 1-2, except that a composition shown in Chemical Formula 7 was included as the main component. At that time, in Examples 2-1 through 2-7, the composition of the first element (the values of x and y in Chemical Formula 7) and the content of strontium zirconate as the second perovskite-type oxide (the value of m in Chemical Formula 7) were changed as shown in Table 3. The content of the sub-component was the same as that in Examples 1-1 and 1-2.

[Chemical Formula 7] (0.995-ₘ)(Na_{1-x-y}KₓLi_{y})NbO₃+mSrZrO₃+0.005BaNb₂O₆

**[Table 3]**

| | COMPOSITION OF MAIN COMPONENT | | | CONTENT OF SUB-COMPONENT Mn* (WT%) | RELATIVE DIELECTRIC CONSTANT *ε* r | ELECTROMECHANICAL COUPLING FACTOR Kr (%) | AMOUNT OF DISPLACEMENT (%) |
|---|---|---|---|---|---|---|---|
| | x (mol) | y (mol) | m (mol) | | | | |
| EXAMPLE 2-1 | 0.19 | 0.05 | 0.08 | 0.31 | 583 | 26.7 | 0.054 |
| EXAMPLE 2-2 | 0.285 | 0.05 | 0.01 | 0.31 | 536 | 34.1 | 0.066 |
| EXAMPLE 2-3 | 0.285 | 0.05 | 0.02 | 0.31 | 766 | 34.5 | 0.079 |
| EXAMPLE 2-4 | 0.36 | 0.1 | 0.01 | 0.31 | 1211 | 33.3 | 0.096 |
| EXAMPLE 2-5 | 0.75 | 0.05 | 0.03 | 0.31 | 620 | 30.4 | 0.063 |
| EXAMPLE 2-6 | 0.6 | 0 | 0.01 | 0.31 | 429 | 40.6 | 0.070 |
| EXAMPLE 2-7 | 0.8 | 0 | 0.08 | 0.31 | 507 | 25.5 | 0.048 |
| COMPARATIVE EXAMPLE 2-1 | 0.19 | 0.05 | 0 | 0.31 | 348 | 30.5 | 0.048 |
| COMPARATIVE EXAMPLE 2-2 | 0.285 | 0.05 | 0 | 0.31 | 344 | 34.8 | 0.052 |
| COMPARATIVE EXAMPLE 2-3 | 0.36 | 0.1 | 0 | 0.31 | 763 | 34.3 | 0.080 |
| COMPARATIVE EXAMPLE 2-4 | 0.75 | 0.05 | 0 | 0.31 | 374 | 32.2 | 0.053 |
| COMPARATIVE EXAMPLE 2-5 | 0.6 | 0 | 0 | 0.31 | 270 | 42.8 | 0.058 |
| COMPARATIVE EXAMPLE 2-6 | 0.8 | 0 | 0 | 0.31 | 239 | 29.2 | 0.040 |

| | | | | | | | |
|---|---|---|---|---|---|---|---|
| * The content of the sub-component is a value as an oxide (MnO) relative to the main component. | | | | | | | |

As Comparative Examples 2-1 through 2-6 relative to the examples, piezoelectric devices were formed as in the case of Examples 2-1 through 2-7, except that strontium zirconate as the second perovskite-type oxide was not included. Comparative Examples 2-1, 2-2, 2-3, 2-4, 2-5, and 2-6 correspond to Examples 2-1, 2-2 and 2-3, 2-4, 2-5, 2-6, and 2-7, respectively.

The relative dielectric constant εr, the electromechanical coupling factor kr and the amount of displacement in the case where an electric field of 3 kV/mm was applied in the piezoelectric devices of Examples 2-1 through 2-7 and Comparative Examples 2-1 through 2-6 were measured as in the case of Examples 1-1 and 1-2. The results are shown in Table 3.

As shown in Table 3, as in the case of Examples 1-1 and 1-2, Examples 2-1 through 2-7 could obtain higher values of relative dielectric constant εr and the amount of displacement than those in the comparative examples. Moreover, there was a tendency that as the value x in Chemical Formula 7 increased, that is, as the content of potassium increased, the relative dielectric constant ε r, the electromechanical coupling factor kr and the amount of displacement were increased to the maximum values, then decreased. In other words, it was clear that when the content of potassium in the first element was within a range from 10 mol% to 90 mol% inclusive, the piezoelectric properties could be improved, and the amount of displacement could be increased.

Moreover, there was a tendency that when lithium was included as the first element, the relative dielectric constant εr, the electromechanical coupling factor kr and the amount of displacement were further increased. In other words, it was clear that when 10 mol% or less of lithium was included in the first element, the piezoelectric properties could be improved, and the amount of displacement could be increased.

### (Examples 3-1, 3-2)

Piezoelectric devices were formed as in the case of Examples 1-1 and 1-2, except that a composition shown in Chemical Formula 8 was included as the main component. At that time, in Examples 3-1 and 3-2, the content of tantalum (the values of z and w in Chemical Formula 8) and the content of strontium zirconate as the second perovskite-type oxide (the value of m in Chemical Formula 8) were changed as shown in Table 4. The content of the sub-component was the same as that in Examples 1-1 and 1-2, and a tantalum oxide (Ta₂O₅) powder was used as the material of tantalum.

[Chemical Formula 8] (0.995-m)(Na_{0.57}K_{0.38}Li_{0.05})(Nb_{1-z}Ta_{z})O₃+mSrZrO₃+0.005Ba(Nb_{1-w}Ta_{w})₂O₆

**[Table 4]**

| | COMPOSITION OF MAIN COMPONENT | | CONTENT OF SUB-COMPONENT Mn* (WT%) | RELATIVE DIELECTRIC CONSTANT *ε* r | ELECTROMECHANICAL COUPLING FACTOR Kr (%) | AMOUNT OF DISPLACEMENT (%) |
|---|---|---|---|---|---|---|
| | z,w (mol) | m (mol) | | | | |
| EXAMPLE 1-1 | 0 | 0.005 | 0.31 | 737 | 38.2 | 0.086 |
| EXAMPLE 1-2 | 0 | 0.01 | 0.31 | 889 | 40.4 | 0.100 |
| EXAMPLE 3-1 | 0.05 | 0.005 | 0.31 | 912 | 41.4 | 0.104 |
| EXAMPLE 3-2 | 0.05 | 0.01 | 0.31 | 1108 | 43.6 | 0.120 |
| COMPARATIVE EXAMPLE 1-1 | 0 | 0 | 0.31 | 535 | 43.1 | 0.083 |
| COMPARATIVE EXAMPLE 3-1 | 0.05 | 0 | 0.31 | 883 | 42.0 | 0.101 |

| | | | | | | |
|---|---|---|---|---|---|---|
| * The content of the sub-component is a value as an oxide (MnO) relative to the main component. | | | | | | |

As Comparative Example 3-1 relative to the examples, a piezoelectric device was formed as in the case of Examples 3-1 and 3-2, except that strontium zirconate as the second perovskite-type oxide was not included. The relative dielectric constant εr, the electromechanical coupling factor kr and the amount of displacement in the case where an electric field of 3 kV/mm was applied in the piezoelectric devices of Examples 3-1 and 3-2 and Comparative Example 3-1 were measured as in the case of Examples 1-1 and 1-2. The results are shown in Table 4 together with the results of Examples 1-1 and 1-2 and Comparative Example 1-1.

As shown in Table 4, as in the case of Examples 1-1 and 1-2, Examples 3-1 and 3-2 could obtain higher values of relative dielectric constant εr and the amount of displacement than those in Comparative Example 3-1. Moreover, Examples 3-1 and 3-2 in which tantalum was included in the second element and the sixth element could obtain a larger amount of displacement than that in Examples 1-1 and 1-2 in which tantalum was not included.

In other words, it was clear that when tantalum was included in the second element or the sixth element, the amount of displacement could be increased.

In the examples, the case where the contents of tantalum in the second element and the sixth element, that is, the values of z and w in Chemical Formula 8 are the same is shown; however, even in the case where the values of z and w are different, the same effects can be obtained.

### (Examples 4-1 to 4-3, 5-1 to 5-13)

Piezoelectric devices were formed as in the case of Example 3-1, except that a composition shown in Chemical Formula 9 as the main component was included, and a sub-component shown in Table 5 or 6 was added. As the material of the second sub-component, a cobalt oxide (Co₃O₄) powder, an iron oxide (Fe₂O₃) powder, a nickel oxide (NiO) powder, a zinc oxide (ZnO) powder, a scandium oxide (Sc₂O₃) powder, a titanium oxide (TiO₂) powder, a zirconium oxide (ZrO₂) powder, a hafnium oxide (HfO₂) powder, an aluminum oxide (Al₂O₃) powder, a gallium oxide (Ga₂O₃) powder, an indium oxide (In₂O₃) powder, a silicon oxide (SiO₂) powder, a germanium oxide (GeO₂) powder or a tin oxide (SnO₂) powder was used. The content of the sub-component shown in Table 5 or 6 was a value as an oxide (MnO, Co₃O₄, Fe₂O₃, NiO, ZnO, Sc₂O₃, TiO₂, ZrO₂, HfO₂, Al₂O₃, Ga₂O₃, In₂O₃, SiO₂, GeO₂, SnO₂) relative to the main component.

[Chemical Formula 9] 0.990(Na_{0.57}K_{0.38}Li_{0.05})(Nb_{0.95}Ta_{0.05})O₃+0.005SrZrO₃+0.005Ba(Nb_{0.95}Ta_{0.05})₂O₆

**[Table 5]**

| | CONTENT OF FIRST SUB-COMPONENT (WT%) | SECOND SUB-COMPONENT | | RELATIVE DIELECTRIC CONSTANT *ε* r | ELECTROMECHANICAL COUPLING FACTOR Kr (%) | AMOUNT OF DISPLACEMENT (%) |
|---|---|---|---|---|---|---|
| | | ELEMENT | CONTENT* (WT%) | | | |
| EXAMPLE 3-1 | 0.31 | — | 0 | 912 | 41.4 | 0.104 |
| EXAMPLE 4-1 | 0.31 | Co | 0.01 | 922 | 43.2 | 0.109 |
| EXAMPLE 4-2 | 0.31 | Co | 0.2 | 944 | 47.2 | 0.120 |
| EXAMPLE 4-3 | 0.31 | Co | 1 | 905 | 44.1 | 0.110 |

| | | | | | | |
|---|---|---|---|---|---|---|
| * The content is a value as an oxide (MnO) relative to the main component. | | | | | | |

**[Table 6]**

| | CONTENT OF FIRST SUB-COMPONENT* (WT%) | SECOND SUB-COMPONENT | | RELATIVE DIELECTRIC CONSTANT *ε* t | ELECTROMECHANICAL COUPLING FACTOR Kr (%) | AMOUNT OF DISPLACEMENT (%) |
|---|---|---|---|---|---|---|
| | | ELEMENT | CONTENT* (WT%) | | | |
| EXAMPLE 3-1 | 0.31 | — | 0 | 912 | 41.4 | 0.104 |
| EXAMPLE 4-2 | 0.31 | Co | 0.2 | 944 | 47.2 | 0.120 |
| EXAMPLE 5-1 | 0.31 | Fe | 0.2 | 943 | 44.5 | 0.113 |
| EXAMPLE 5-2 | 0.31 | Ni | 0.2 | 929 | 44.8 | 0.113 |
| EXAMPLE 5-3 | 0.31 | Zn | 0.2 | 948 | 46.1 | 0.118 |
| EXAMPLE 5-4 | 0.31 | Sc | 0.2 | 979 | 45.1 | 0.117 |
| EXAMPLE 5-5 | 0.31 | Ti | 0.2 | 1117 | 42.3 | 0.117 |
| EXAMPLE 5-6 | 0.31 | Zr | 0.2 | 1200 | 40.8 | 0.117 |
| EXAMPLE 5-7 | 0.31 | Hf | 0.2 | 1060 | 43.2 | 0.117 |
| EXAMPLE 5-8 | 0.31 | Al | 0.2 | 1038 | 41.2 | 0.110 |
| EXAMPLE 5-9 | 0.31 | Ga | 0.2 | 1116 | 41.5 | 0.115 |
| EXAMPLE 5-10 | 0.31 | In | 0.2 | 1055 | 41.1 | 0.111 |
| EXAMPLE 5-11 | 0.31 | Si | 0.2 | 1028 | 40.3 | 0.107 |
| EXAMPLE 5-12 | 0.31 | Ge | 0.2 | 1100 | 43.4 | 0.119 |
| EXAMPLE 5-13 | 0.31 | Sn | 0.2 | 1050 | 42.0 | 0.113 |

| | | | | | | |
|---|---|---|---|---|---|---|
| * The content is a value as an oxide (MnO) relative to the main component. | | | | | | |

The relative dielectric constant εr, the electromechanical coupling factor kr and the amount of displacement in the case where an electric field of 3 kV/mm was applied in the piezoelectric devices of Examples 4-1 through 4-3 and Examples 5-1 through 5-13 were measured as in the case of Examples 1-1 and 1-2. The results are shown in Tables 5 and 6 together with the results of Example 3-1.

As shown in Table 5, in Examples 4-1 through 4-3 in which cobalt was added as the second sub-component, a larger amount of displacement than that in Example 3-1 in which the second sub-component was not included was obtained. Moreover, it was obvious from a comparison between Examples 4-1 through 4-3 that there was a tendency that when the content of cobalt as the second sub-component increased, the amount of displacement increased to the maximum value, then decreased.

Further, as shown in Table 6, when iron, nickel, zinc, scandium, titanium, zirconium, hafnium, aluminum, gallium, indium, silicon, germanium or tin was included as the second sub-component, as in the case where cobalt was included, an improvement in the amount of displacement was observed.

In other words, it was clear that when at least one kind selected from the group consisting of cobalt, iron, nickel, zinc, scandium, titanium, zirconium, hafnium, aluminum, gallium, indium, silicon, germanium and tin was included as the second sub-component, the piezoelectric properties could be further improved. Moreover, it was clear that the total content of the second sub-component as an oxide was preferably within a range from 0.01 wt% to 1 wt% inclusive relative to the main component.

In the above examples, some compositions including the first perovskite-type oxide, the second perovskite-type oxide and the tungsten bronze-type oxide are described as examples in detail. However, as long as a composition is within a range described in the above embodiment, the same effects can be obtained.

Although the present invention is described referring to the embodiment and the examples, the invention is not limited to the above embodiment and the above examples, and is variously modified. For example, in the above embodiment and the above examples, the case where the composition including the first perovskite-type oxide, the second perovskite-type oxide and the tungsten bronze-type oxide is included is described; however, any other component may be further included in the composition in addition to the first perovskite-type oxide, the second perovskite-type oxide and the tungsten bronze-type oxide.

Moreover, in the above embodiment and the examples, the case where the composition of the main component includes at least sodium and potassium selected from the group consisting of sodium, potassium and lithium as the first element, at least niobium selected from the group consisting of niobium and tantalum as the second element, at least one kind selected from alkaline-earth metal elements as the third element, at least titanium as the fourth element, at least one kind selected from alkaline-earth metal elements as the fifth element, and at least niobium selected from the group consisting of niobium and tantalum as the sixth element is described; however, each of the first element, the second element, the third element, the fourth element, the fifth element and the sixth element may further include any other element.

Further, in the above embodiment and the examples, the case where the sub-component is included in addition to the composition of the main component is described; however, as long as the composition of the main component is included, the invention can be widely applied to the case where the sub-component is not included. Further, the invention can be applied to the case where any other sub-component is included in a like manner.

In addition, in the above embodiment, although the piezoelectric device with a single-layer structure is described, the invention can be applied to a piezoelectric device with any other structure such as a multilayer structure in a like manner. Further, although a vibration device such as an actuator, a sound component and a sensor are taken as examples of the piezoelectric device, the invention can be applied to any other piezoelectric device.

### INDUSTRIAL APPLICABILITY

The piezoelectric ceramic can be used in piezoelectric devices including vibration device such as actuators, sound components and sensors.

## Claims

1. A piezoelectric ceramic (1),
comprising a composition including a first perovskite-type oxide, a second perovskite-type oxide and a tungsten bronze-type oxide,
wherein the first perovskite-type oxide includes a first element including sodium (Na) and potassium (K), a second element including at least niobium (Nb) selected from the group consisting of niobium and tantalum (Ta), and oxygen (O),
the second perovskite-type oxide includes a third element including at least strontium (Sr) selected from an alkaline-earth metal element, a fourth element including zirconium (Zr), and oxygen, and
the content of the second perovskite-type oxide in the composition is less than 10 mol%.

2. The piezoelectric ceramic (1) according to claim 1,
wherein the content of potassium in the first element is within a range from 10 mol% to 90 mol% inclusive.

3. The piezoelectric ceramic (1) according to claim 1,
wherein lithium is further included as the first element, and the content of lithium in the first element is 10 mol% or less.

4. The piezoelectric ceramic (1) according to claim 1,
wherein the content of the tungsten bronze-type oxide in the composition is 1 mol% or less.

5. The piezoelectric ceramic (1) according to claim 1,
wherein the tungsten bronze-type oxide includes:
a fifth element including an alkaline-earth metal element;
a sixth element including at least niobium selected from the group consisting of niobium and tantalum; and
oxygen.

6. The piezoelectric ceramic (1) according to claim 5.
wherein the total content of tantalum in the second element and the sixth element is within a range from 0 mol% to 10 mol% inclusive.

7. The piezoelectric ceramic (1) according to claim 1,
wherein the composition is considered as a main component, and as a sub-component, at least one kind selected from the group consisting of elements of Groups 3 through 14 in the long form of the periodic table of the elements is included.

8. The piezoelectric ceramic (1) according to claim 7,
wherein as a first sub-component, the sub-component includes manganese as an oxide (MnO) within a range from 0.1 wt% to 1 wt% inclusive relative to the main component.

9. The piezoelectric ceramic (1) according to claim 8,
wherein in addition to the first sub-component, as a second sub-component, the sub-component includes at least one kind selected from the group consisting of cobalt (Co), iron (Fe), nickel (Ni), zinc (Zn), scandium (Sc), titanium (Ti), zirconium (Zr), hafnium (Hf), aluminum (Al), gallium (Ga), indium (In), silicon (Si), germanium (Ge) and tin (Sn) as an oxide (Co₃O₄, Fe₂O₃, NiO, ZnO, Sc₂O₃, TiO₂, ZrO₂, HfO₂, Al₂O₃, Ga₂O₃, In₂O₃, SiO₂, GeO₂, SnO₂) within a range from 0.01 wt% to 1 wt% inclusive relative to the main component in total.

10. A method of manufacturing a piezoelectric ceramic (1),
the piezoelectric ceramic (1) including a first perovskite-type oxide, a second perovskite-type oxide and a tungsten bronze-type oxide, the first perovskite-type oxide including a first element including sodium (Na) and potassium (K), a second element including at least niobium (Nb) selected from the group consisting of niobium and tantalum (Ta), and oxygen (O), the second perovskite-type oxide including a third element including at least one kind selected from alkaline-earth metal elements, a fourth element including zirconium (Zr) and oxygen,
the method comprising the step of calcining a mixture including elements of the first perovskite-type oxide, the second perovskite-type oxide, and elements of the tungsten bronze-type oxide.

## Patentansprüche

1. Piezoelektrische Keramik (1),
die eine Zusammensetzung enthält, die ein erstes Oxid vom Perowskit-Typ, ein zweites Oxid von Perowskit-Typ und ein Oxid vom Wolfram-Bronze-Typ enthält,
wobei das erste Oxid vom Perowskit-Typ ein erstes Element, das Natrium (Na) und Kalium (K) enthält, ein zweites Element, das wenigstens Niob (Nb) enthält, das aus der Gruppe ausgewählt ist, die aus Niob und Tantal (Ta) besteht, und Sauerstoff (O) enthält,
wobei das zweite Oxid vom Perowskit-Typ ein drittes Element, das wenigstens Strontium (Sr) enthält, das aus einem Erdalkalimetallelement ausgewählt ist, ein viertes Element, das Zirkonium (Zr) enthält, und Sauerstoff enthält, und wobei
der Gehalt des zweiten Oxids vom Perowskit-Typ in der Zusammensetzung weniger als 10 Mol-% beträgt.

2. Piezoelektrische Keramik (1) nach Anspruch 1,
wobei der Gehalt des Kaliums in dem ersten Element innerhalb eines Bereichs von einschließlich 10 Mol-% bis 90 Mol-% liegt.

3. Piezoelektrische Keramik (1) nach Anspruch 1,
wobei als das erste Element ferner Lithium enthalten ist und der Gehalt des Lithiums in dem ersten Element 10 Mol-% oder weniger beträgt.

4. Piezoelektrische Keramik (1) nach Anspruch 1,
wobei der Gehalt des Oxids vom Wolfram-Bronze-Typ in der Zusammensetzung 1 Mol-% oder weniger beträgt.

5. Piezoelektrische Keramik (1) nach Anspruch 1,
wobei das Oxid vom Wolfram-Bronze-Typ enthält:
ein fünftes Element, das ein Erdalkalimetallelement enthält;
ein sechstes Element, das wenigstens Niob enthält, das aus der Gruppe ausgewählt ist, die aus Niob und Tantal besteht; und
Sauerstoff.

6. Piezoelektrische Keramik (1) nach Anspruch 5,
wobei der Gesamtgehalt des Tantals in dem zweiten Element und in dem sechsten Element innerhalb eines Bereichs von einschließlich 0 Mol-% bis 10 Mol-% liegt.

7. Piezoelektrische Keramik (1) nach Anspruch 1,
wobei die Zusammensetzung als eine Hauptkomponente angesehen wird und als eine Unterkomponente wenigstens eine Art enthalten ist, die aus der Gruppe ausgewählt ist, die aus Elementen der Gruppen 3 bis 14 in der Langform des Periodensystems der Elemente besteht.

8. Piezoelektrische Keramik (1) nach Anspruch 7,
wobei als eine erste Unterkomponente die Unterkomponente Mangan als ein Oxid (MnO) innerhalb eines Bereichs von einschließlich 0,1 Gew.-% bis 1 Gew.-% relativ zu der Hauptkomponente enthält.

9. Piezoelektrische Keramik (1) nach Anspruch 8,
wobei zusätzlich zu der ersten Unterkomponente als eine zweite Unterkomponente die Unterkomponente wenigstens eine Art enthält, die aus der Gruppe ausgewählt ist, die aus Kobalt (Co), Eisen (Fe), Nickel (Ni), Zink (Zn), Scandium (Sc), Titan (Ti), Zirkonium (Zr), Hafnium (Hf), Aluminium (A1), Gallium (Ga), Indium (In), Silicium (Si), Germanium (Ge) und Zinn (Sn) als ein Oxid (Co₃O₄, Fe₂O₃, NiO, ZnO, Sc₂O₃, TiO₂, ZrO₂, HfO₂, Al₂O₃, Ga₂O₃, In₂O₃, SiO₂, GeO₂, SnO₂) innerhalb eines Bereichs von insgesamt einschließlich 0,01 Gew.-% bis 1 Gew.-% relativ zu der Hauptkomponente besteht.

10. Verfahren zum Herstellen einer piezoelektrischen Keramik (1),
wobei die piezoelektrische Keramik (1) ein erstes Oxid vom Perowskit-Typ, ein zweites Oxid von Perowskit-Typ und ein Oxid vom Wolfram-Bronze-Typ enthält, wobei das erste Oxid vom Perowskit-Typ ein erstes Element, das Natrium (Na) und Kalium (K) enthält, ein zweites Element, das wenigstens Niob (Nb) enthält, das aus der Gruppe ausgewählt ist, die aus Niob und Tantal (Ta) besteht, und Sauerstoff (O) enthält, wobei das zweite Oxid vom Perowskit-Typ ein drittes Element, das wenigstens eine Art enthält, die aus aus Erdalkalimetallelementen ausgewählt ist, ein viertes Element, das Zirkonium (Zr) enthält, und Sauerstoff enthält,
wobei das Verfahren den Schritt des Kalzinierens eines Gemischs enthält, das Elemente des ersten Oxids vom Perowskit-Typ, des zweiten Oxids vom Perowskit-Typ und Elemente des Oxids vom Wolfram-Bronze-Typ enthält.

## Revendications

1. Céramique piézoélectrique (1),
comprenant une composition contenant un premier oxyde de type pérovskite, un second oxyde de type pérovskite et un oxyde à base de tungstène/bronze,
dans laquelle le premier oxyde de type pérovskite comprend un premier élément comprenant le sodium (Na) et le potassium (K), un deuxième élément comprenant au moins le niobium (Nb) choisi dans le groupe constitué par le niobium et le tantale (Ta), et de l'oxygène (O),
le second oxyde de type pérovskite comprend un troisième élément comprenant au moins le strontium (Sr) choisi parmi un élément métallique alcalino-terreux, un quatrième élément comprenant le zirconium (Zr), et de l'oxygène, et
la teneur en second oxyde de type pérovskite dans la composition est inférieure à 10 % en mole.

2. Céramique piézoélectrique (1) selon la revendication 1,
dans laquelle la teneur en potassium dans le premier élément est située dans une plage allant de 10 % en mole à 90 % en mole inclus.

3. Céramique piézoélectrique (1) selon la revendication 1,
dans laquelle du lithium est en outre inclus dans le premier élément, et la teneur en lithium dans le premier élément est inférieure ou égale à 10 % en mole.

4. Céramique piézoélectrique (1) selon la revendication 1,
dans laquelle la teneur en oxyde à base de tungstène/bronze dans la composition est inférieure ou égale à 1 % en mole.

5. Céramique piézoélectrique (1) selon la revendication 1,
dans laquelle l'oxyde à base de tungstène/bronze comprend :
un cinquième élément comprenant un élément métallique alcalino-terreux ;
un sixième élément comprenant au moins le niobium choisi dans le groupe constitué par le niobium et le tantale ; et
de l'oxygène.

6. Céramique piézoélectrique (1) selon la revendication 5,
dans laquelle la teneur totale en tantale dans le deuxième élément et le sixième élément est située dans une plage allant de 0 % en mole à 10 % en mole inclus.

7. Céramique piézoélectrique (1) selon la revendication 1,
dans laquelle la composition est considérée comme composant principal, et en tant que sous-composant, au moins un type choisi dans le groupe constitué par les éléments des groupes 3 à 14 de la forme étendue du tableau périodique des éléments est inclus.

8. Céramique piézoélectrique (1) selon la revendication 7,
dans laquelle en tant que premier sous-composant, le sous-composant comprend du manganèse sous forme d'oxyde (MnO) à un taux de 0,1 % en poids à 1 % en poids inclus par rapport au composant principal.

9. Céramique piézoélectrique (1) selon la revendication 8,
dans laquelle en plus du premier sous-composant, en tant que second sous-composant, le sous-composant comprend au moins un type choisi dans le groupe constitué par le cobalt (Co), le fer (Fe), le nickel (Ni), le zinc (Zn), le scandium (Sc), le titane (Ti), le zirconium (Zr), le hafnium (Hf), l'aluminium (Al), le gallium (Ga), l'indium (In), le silicium (Si), le germanium (Ge) et l'étain (Sn) sous forme d'oxyde (Co₃O₄, Fe₂O₃, NiO, ZnO, Sc₂O₃, TiO₂, ZrO₂, HfO₂, Al₂O₃, Ga₂O₃, In₂O₃, SiO₂, GeO₂, SnO₂) à un taux de 0,01 % en poids à 1 % en poids inclus par rapport au composant principal au total.

10. Procédé de fabrication d'une céramique piézoélectrique (1),
la céramique piézoélectrique (1) comprenant un premier oxyde de type pérovskite, un second oxyde de type pérovskite et un oxyde à base de tungstène/bronze, le premier oxyde de type pérovskite comprenant un premier élément comprenant le sodium (Na) et le potassium (K), un deuxième élément comprenant au moins le niobium (Nb) choisi dans le groupe constitué par le niobium et le tantale (Ta), et de l'oxygène (O), le second oxyde de type pérovskite comprenant un troisième élément comprenant au moins un type choisi parmi les éléments métalliques alcalino-terreux, un quatrième élément comprenant le zirconium (Zr), et de l'oxygène,
le procédé comprenant l'étape consistant à calciner un mélange contenant les éléments du premier oxyde de type pérovskite, le second oxyde de type pérovskite et les éléments de l'oxyde à base de tungstène/bronze.
